# EUROPÄISCHE PATENTANMELDUNG

(11) **EP 2 146 372 A2**
(43) Veröffentlichungstag der Anmeldung: **20.01.2010**
(21) Anmeldenummer: 09008708.1
(22) Anmeldetag: 03.07.2009
(51) Int. Cl.: H01L 21/60, H01L 23/498

(54) **Leistungselektronische Verbindungseinrichtung und Herstellungsverfahren hierzu**

(30) Priorität: 16.07.2008 DE 102008033410
(71) Anmelder: Semikron Elektronik GmbH & Co. KG Patentabteilung, 90431 Nürnberg (DE)
(72) Erfinder: Scheuermann, Uwe, 90419 Nürnberg (DE)

(57) **Zusammenfassung**

Die Erfindung beschreibt eine leistungselektronische Verbindungseinrichtung mit einer ersten (120) und einer zweiten (220) voneinander elektrisch isolierten Kontaktfläche, mit jeweils mindestens einem einer Edelmetalloberfläche (160,260) aufweisenden Kontaktbereich (16,26) auf diesen Kontaktflächen, je einer auf den Kontaktbereichen angeordneten Sintermetallschicht (18,28) und einem flexiblen Verbindungselement (4). Hierbei weist dieses Verbindungselement eigene dritte (40) und vierte (42) Kontaktbereiche mit jeweils einer Edelmetalloberfläche auf. Ebenso sind diese dritten und vierten Kontaktbereiche mit den Sintermetallschichten der ersten und zweiten Kontaktflächen elektrisch leitend verbunden. Die erste Kontaktfläche (120) kann auf einer Metallisierung (14) eines Substrats angeordnet sein une die zweite Kontaktfläche (220) kann auf einem Leistungshalbleiterbauelement (1) angeordnet sein.

## Beschreibung

Die Erfindung beschreibt eine leistungselektronische Verbindungseinrichtung mit einer ersten und einer zweiten voneinander elektrisch isolierten Kontaktfläche und einem zwischen diesen Kontaktflächen angeordneten und diese elektrisch leitend verbindenden Verbindungselement. Grundsätzlich bekannt sind derartige Verbindungseinrichtungen aus Leistungshalbleitermodulen, wie sie beispielhaft in der DE 103 16 356 A1 offenbart sind, und dort zur Verbindung einer Kontaktfläche eines Leistungshalbleiterbauelements mit einer Leiterbahn eines Substrats dienen.

Den Stand der Technik hierzu bilden die hinlänglich bekannten Bond-, speziell Drahtbondverbindungen. Die im Anwendungsbereich der Leistungselektronik hier meist eingesetzte Variante ist die Dickdraht- Wedge- Wedge- Ultraschallbondverbindung. Hierbei wird als Verbindungselement in der Regel Aluminiumdraht mit einem maximalen Durchmesser von 500µm verwendet. Grundsätzlich bekannt sind alternativ zu den Bonddrähten auch sog. Bondbändchen aus Aluminium mit einem rechteckigem Querschnitt bei einer größeren Querschnittsfläche im Vergleich zu Bonddrähten und hierdurch begründeter einer höheren Stromtragfähigkeit. Derartige Verbindungseinrichtungen sind beispielhaft aus der WO 2004/100258 A2 bekannt.

Allen bisher bekannten Bondverbindungen in Leistungshalbleitermodulen weisen beispielhaft im Vergleich zu druckkontaktierten Aufbauten den Nachteil geringerer Dauerhaltbarkeit auf. Demgegenüber steht die hohe Flexibilität derartiger Verbindungen, speziell bei der Ausbildung komplexer Verbindungstopologien.

Bekannt sind als Alternativen zu den Bondverbindungen in Leistungshalbleitermodulen, diejenigen mit druckkontaktierten oder druckgesinterten Verbindungseinrichtungen. Beispielhaft die DE 100 65 495 A1 offenbart einen druckkontaktierten Aufbau, wobei die beiden Kontaktflächen eines Leistungshalbleiterbauelements mit flächigen Metallformkörpern zur Stromzu- und Stromableitung kraftschlüssig miteinander verbunden sind. Derartige Verbindungseinrichtungen weisen eine besonders hohe Dauerhaltbarkeit speziell auch bei den im Betrieb auftretenden Last- und Temperaturwechseln auf.

Weiterhin ist aus der DE 10 2005 050 534 A1 ein Leistungshalbleitermodul bekannt, wobei die Verbindungseinrichtung durch Drucksinterverbindung an sich bekannter Verbindungselemente mit Leiterbahnen oder auch mit Leistungshalbleiterbauelementen ausgebildet ist. Nachteilig bei diesen, wie auch den druckkontaktierten, Verbindungseinrichtungen ist allerdings deren gegenüber Bondverbindungen eingeschränkte Flexibilität in Bezug auf die möglichen Verbindungstopologien.

Der Erfindung liegt die Aufgabe zugrunde eine leistungselektronische Verbindungseinrichtung mit zugehörigem Herstellungsverfahren vorzustellen, wobei die Stromtragfähigkeit des Verbindungselements gegenüber Drahtbondverbindungen erhöht wird und wobei die Dauerhaltbarkeit gegenüber Bondverbindungen verbessert wird ohne deren Flexibilität stark einzuschränken.

Diese Aufgabe wird erfindungsgemäß gelöst, durch eine Verbindungseinrichtung mit den Merkmalen des Anspruchs 1, sowie durch ein zugeordnetes Herstellungsverfahren nach Anspruch 2. Bevorzugte Ausführungsformen sind in den abhängigen Ansprüchen beschrieben.

Ausgangspunkte der erfindungsgemäßen Lösung sind Verbindungseinrichtungen für Leistungshalbleitermodule gemäß dem oben beschrieben Stand der Technik. Hierbei muss mindestens eine Kontaktfläche eines Leistungshalbleiterbauelements mit einer Kontaktfläche eines Substrats verbunden werden. Besonderes Augenmerk liegt allerdings auf komplexeren Verbindungstopologien einer Mehrzahl von Leistungshalbleiterbauelementen miteinander und / oder mit unterschiedlichen, meist auch voneinander elektrisch isolierten, Kontaktflächen auf einem Substrat.

Die erfindungsgemäße Verbindungseinrichtung weist eine erste und eine hiermit zu verbindende zweite, voneinander elektrisch isolierte, Kontaktfläche auf. Jede dieser beiden Kontaktflächen weist mindestens einen Kontaktbereich auf, der wiederum jeweils eine Edelmetalloberfläche aufweist. Hierbei kann es vorteilhaft sein, wenn die jeweilige Kontaktfläche vollständig aus Edelmetall, wie beispielhaft Silber, besteht. Es kann allerdings auch bevorzugt sein, wenn die Kontaktfläche aus einem beliebigen Metall mit einem meist lokal begrenzten Überzug eines Edelmetalls, wie beispielhaft Gold oder Platin, besteht.

Diese Kontaktbereiche weisen eine den jeweiligen Kontaktbereich nicht notwendigerweise vollständig bedeckende Sintermetallschicht aus einem Edelmetall, meist als Silberflocken ausgestaltet, auf. Die ersten und zweiten Kontaktbereiche sind mittels mindestens eines flexiblen Verbindungselements elektrisch leitend miteinander verbunden.

Hierzu weist das Verbindungselement dritte und vierte Kontaktbereiche zur nicht notwendigerweise vollflächig ausgebildeten elektrisch leitenden Verbindung mit den Sintermetallschichten der ersten und zweiten Kontaktbereiche auf. Diese dritten und vierten Kontaktbereiche weisen ihrerseits eine Edelmetalloberfläche auf. Hierbei kann es bevorzugt sein, wenn diese als ein Überzug ausgebildet ist, allerdings kann es alternativ besonderes bevorzugt sein das gesamte Verbindungselement aus einem Edelmetallwerkstoff auszubilden.

Das erfindungsgemäße Verfahren zur Herstellung einer derartigen Verbindungseinrichtung weist die folgenden wesentlichen Schritte auf:
a) Anordnung, vorzugsweise mittels eines Dispensverfahrens, einer Paste mit Sintermetall auf den ersten und zweiten, jeweils Edelmetalloberflächen aufweisenden, Kontaktbereichen der Kontaktflächen, wobei diese Paste vorzugsweise ein Lösungsmittel aufweist, das vor dem nächsten Schritt möglichst vollständig ausgetrieben wird;
b) nicht notwendigerweise vollflächige Anordnung des dritten Kontaktbereichs des flexiblen Verbindungselements auf dem Sintermetall des ersten Kontaktbereichs der ersten Kontaktfläche;
c) Beaufschlagung der Kontakteinrichtung auf den dritten Kontaktbereich mit Druck vorzugsweise im Bereich zwischen 5MPa und 80MPa und mit Temperatur, vorzugsweise im Bereich zwischen 100°C und 300°C;
d) nicht notwendigerweise vollflächige Anordnung des vierten Kontaktbereichs des flexiblen Verbindungselements auf dem Sintermetall des zweiten Kontaktbereichs der zweiten Kontaktfläche;
e) analog zu Schritt c): Beaufschlagung der Kontakteinrichtung auf den vierten Kontaktbereich mit Druck und mit Temperatur; wobei dieser Schritt ohne Beschränkung der Allgemeinheit mit dem Schritt c) vertauscht werden kann.

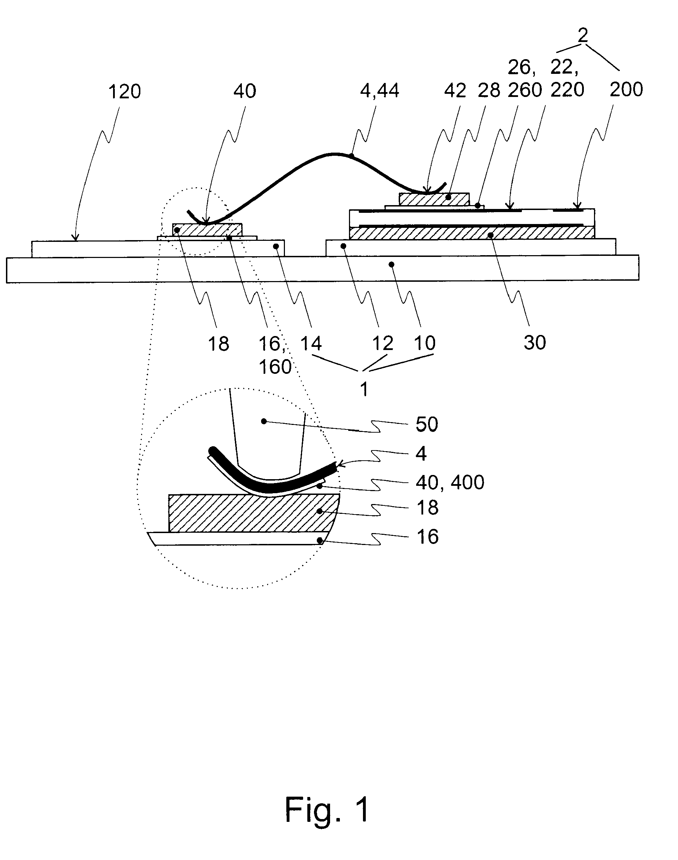

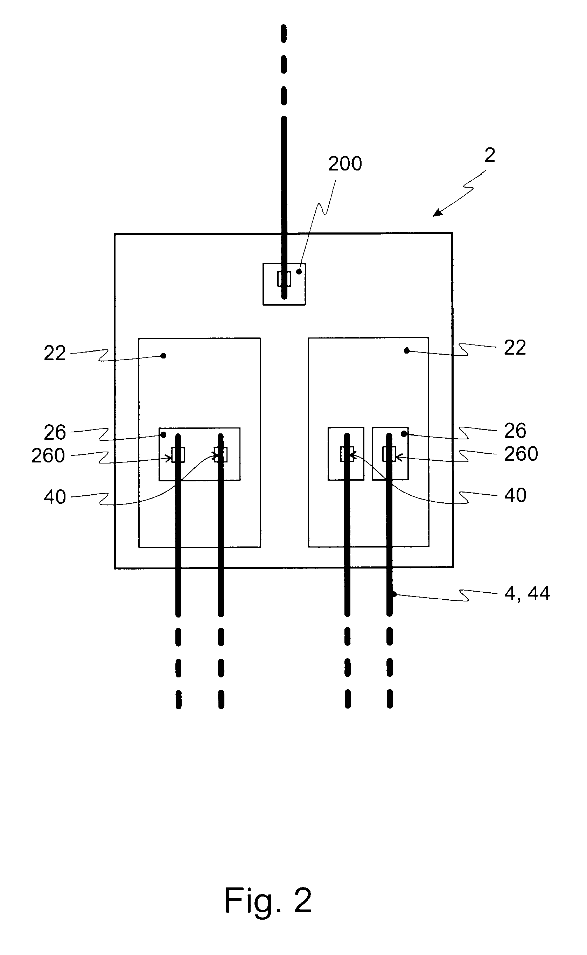

Besonders bevorzugte Weiterbildungen dieser Verbindungseinrichtung sind in der jeweiligen Beschreibung der Ausführungsbeispiele genannt. Die erfinderische Lösung wird zudem an Hand der Ausführungsbeispiele der Fig. 1 und 2 weiter erläutert.

Fig. 1 zeigt eine erfindungsgemäße Verbindungseinrichtung an der beispielhaften Anwendung in einem Leistungshalbleitermodul im Querschnitt.

Fig. 2 zeigt einen Teil der Verbindungseinrichtung gemäß Fig. 1 in Draufsicht.

Fig. 1 zeigt eine erfindungsgemäße Verbindungseinrichtung an der beispielhaften Anwendung in einem Leistungshalbleitermodul im Querschnitt. Dargestellt ist ein Substrat (1) mit einer Isolierschicht (10) und zwei voneinander elektrisch isolierten Leiterbahnen (12, 14). Die erste Leiterbahn (12) dient hierbei der schaltungsgerechten Verbindung im Inneren des Leistungshalbleitermoduls und weist eine elektrisch leitfähige Oberfläche, die erste Kontaktfläche (120) der erfindungsgemäßen Verbindungseinrichtung, auf. Auf dieser ersten Kontaktfläche (120) ist ein räumlich begrenzter erster Kontaktbereich (16) mit einer Edelmetalloberfläche (160) angeordnet. Hierbei ist es besonders bevorzugt, wenn die erste Leiterbahn (12) aus Kupfer besteht und die Edelmetalloberfläche (160) als eine dünne Goldschicht mit einer Dicke zwischen 10nm und 150nm ausgebildet ist. Es kann allerdings auch bevorzugt sein die erste Leiterbahn (12) aus einem Edelmetallwerkstoff, vorzugsweise aus Silber, auszubilden. Auf der Edelmetalloberfläche (160) des ersten Kontaktbereichs (16) ist eine nicht vollflächige Sintermetallschicht (18) mit einer bevorzugten Dicke zwischen 20µm und 200µm angeordnet.

Die zweite Leiterbahn (14) des Substrats (1) ist hier identisch der ersten Leiterbahn (12) ausgebildet und hierauf ist mittels eines bekannten, hier nicht weiter beschriebenen, Verfahren, wie Drucksintern oder Löten, ein Leistungshalbleiterbauelement (4) angeordnet. Dies Leistungshalbleiterbauelement (4) kann eine Leistungsdiode, oder wie hier dargestellt ein Leistungstransistor sein.

Das Leistungshalbleiterbauelement (2) weist auf seine dem Substrat abgewandten Hauptfläche einen Lastanschlussbereich (22) mit mindestens einer Kontaktfläche (220) zur Lastverbindung und einen Steueranschlussbereich mit Kontaktfläche (220) zur Steuerverbindung auf. Die hier dargestellte Verbindungseinrichtung bildet die elektrisch leitende Verbindung dieser Lastanschlussfläche, der zweiten Kontaktfläche (220) der Verbindungseinrichtung, mit der ersten Kontaktfläche (120) auf dem Substrat (1). Hierzu weist die zweite Kontaktfläche (220) einen Kontaktbereich (26) auf, wobei dieser eine Edelmetalloberfläche (260) aufweist. Vorzugsweise bedeckt diese Edelmetalloberfläche (260) die gesamte Kontaktfläche (220), oder wie hier dargestellt nur einen zweiten Kontaktbereich (260) der Verbinungseinrichtung. Diese Edelmetalloberfläche (260) ist bei Leistungshalbleiterbauelementen (2) typischerweise als letzte Lage eine mehrschichtig mittels verschiedener metallischer Schichten ausgebildet Kontaktmetallisierung ausgebildet. Auf diesem zweiten Kontaktbereich (26) ist eine nicht vollflächig diesen Kontaktbereich (26) überdeckende Sintermetallschicht (28) analog der oben genannten angeordnet.

Das flexible Verbindungselement (4) zur elektrisch leitenden Verbindung der ersten (120) mit der zweiten (220) Kontaktfläche ist hier als bandartiger Metallformkörper mit einer Breite zwischen 0,5mm und 5mm und einer Dicke zwischen 0,1mm und 2mm ausgestaltet. Das Verbindungselement (4) weist somit eine vergleichbare Dimensionierung wie die bekannten Bondbändchen auf. Das Verbindungselement (4) besteht vorzugsweise zu mindestens 90 von 100 aus Silber, Kupfer oder Aluminium. Bei einem entsprechend hohen Edelmetallanteil kann auf eine zusätzliche Edelmetallschicht in den Kontaktbereichen (40, 42) des Verbindungselements, den dritten und vierten Kontaktbereichen der Verbindungseinrichtung, verzichtet werden. Bei einer ebenso möglichen Ausgestaltung aus Kupfer weisen die Kontaktbereiche (40, 42) des Verbindungselements (4) eine Edelmetalloberfläche (400) mit eine Dicke zwischen 10nm und 150nm auf. Diese Edelmetalloberfläche (400) ist hier dargestellt und ist dabei ausschließlich auf der dem Sintermetall (18) zugewandte Längsseite des Kontaktbereichs (40) vorgesehen. Es kann auch vorteilhaft sein, wenn die Edelmetalloberfläche den Endbereich des Verbindungselements vollständig an allen Längsseiten überdeckt.

Im Rahmen des erfindungsgemäßen Herstellungsverfahrens werden die beiden Sintermetallschichten (18, 28) angeordnet indem eine Sinterpaste auf die entsprechenden Kontaktbereiche (16, 26) mittels eines Dispensverfahren aufgebracht wird. Hierbei besteht die Sinterpaste aus dem Sintermetall, das in Form von Metallflocken von vorzugsweise nicht mehr als 200µm Ausdehnung vorliegt und einem Lösungsmittel zur Ausbildung der pastösen Eigenschaft. Das Mischungsverhältnis kann hierbei von 20:80 bis 80:20 variieren.

Anschließend an ein bevorzugtes Austreiben des Lösungsmittels aus der Sinterpaste wird der dritte Kontaktbereich (40) des Verbindungselements auf der nun entstandenen Sintermetallschicht (28) des ersten Kontaktbereichs (16) angeordnet. Mittels einer vorzugsweise eine Temperatur von 250°C aufweisenden Druckeinrichtung (50) wird nun Druck von beispielhaft 40MPa auf das Kontaktbereich (40) des Verbindungselements (4) eingeleitet. Bei einer beispielhaften flächenmäßigen Ausdehnung der Verbindungsstelle zwischen erstem (16) und dritten (40) Kontaktbereich der Verbindungseinrichtung von 1mm² entspricht diese einer von der Druckeinrichtung (50) aufzubringenden Kraft von 40N. Hierdurch entsteht eine elektrisch leitende stoffschlüssige Verbindung zwischen dem ersten (16) und dritten (40) Kontaktbereich.

Nach Anordnung des vierten Kontaktbereichs (42) des Verbindungselements (4) zum zweiten Kontaktbereich (26), wobei das Verbindungselement (4) in seinem Verlauf einen Bogen (44) ausbildet, wird der vierte Kontaktbereich (42) in analoger Weise mit dem zweiten Kontaktbereich (26) elektrisch leitend verbunden. Es versteht sich von selbst, dass die Reihenfolge der beiden Verbindungen weder Einfluss auf die Funktion des Verfahrens noch auf die dadurch entstandene Verbindungseinrichtung ausübt. Es kann weiterhin besonders bevorzugt sein im Rahmen der Verbindungseinrichtung eine Mehrzahl von Verbindungselementen (4) anzuordnen.

Fig. 2 zeigt einen Teil der Verbindungseinrichtung gemäß Fig. 1 in Draufsicht. Dargestellt ist das Leistungshalbleiterbauelement (2) mit zwei Lastanschlussflächen (22), die hier zwei zweite Kontaktflächen der Verbindungseinrichtung ausbilden. Weiterhin dargestellt sind zwei spezielle Varianten der Verbindungseinrichtung mit jeweils zwei Verbindungselementen (4). Auf der linken zweiten Kontaktfläche (22) ist ein Kontaktbereich (26) angeordnet, der eine Edelmetalloberfläche (260) aufweist und von dem beide dargestellten Verbindungselemente (4) ausgehen. Demgegenüber sind auf der rechten zweiten Kontaktfläche (22) je von dort ausgehendem Verbindungselement (4) je ein Kontaktbereich (26) mit eigener Edelmetalloberfläche (260) vorgesehen. Die hier dargestellten Variationsmöglichkeiten gelten analog auch für erste Kontaktflächen (26), beispielhaft auf dem Substrat (1).

Weiterhin weist das dargestellte Leistungshalbleiterbauelement (2) eine Steueranschlussfläche (200) auf, die eine analoge Verbindungseinrichtung aufweist.

## Patentansprüche

1. Leistungselektronische Verbindungseinrichtung mit einer ersten (120) und einer zweiten (220) voneinander elektrisch isolierten Kontaktfläche, mit jeweils mindestens einem einer Edelmetalloberfläche (160, 260) aufweisenden Kontaktbereich (16, 26) auf diesen Kontaktflächen (120, 220), je einer auf den Kontaktbereichen (16, 26) angeordneten Sintermetallschicht (18, 28) und einem flexiblen Verbindungselement (4), wobei dieses Verbindungselement (4) eigene dritte (40) und vierte (42) Kontaktbereiche mit jeweils einer Edelmetalloberfläche (160, 260) aufweist und diese dritten (40) und vierten (42) Kontaktbereiche mit den Sintermetallschichten (18, 28) der ersten (120) und zweiten (220) Kontaktflächen elektrisch leitend verbunden sind.

2. Verbindungseinrichtung nach Anspruch 1,
wobei die erste Kontaktfläche (120) auf einer Metallisierung (14) eines Substrats (1) angeordnet ist und wobei die zweite Kontaktfläche (220) auf einem Leistungshalbleiterbauelement (1) angeordnet ist.

3. Verbindungseinrichtung nach Anspruch 1,
wobei das flexible Verbindungselement (4) als bandartiger Metallformkörper mit einer Breite zwischen 0,5mm und 5mm und einer Dicke zwischen 0,1mm und 2mm ausgestaltet ist.

4. Verbindungseinrichtung nach Anspruch 1,
wobei das flexible Verbindungselement (4) zu mindestens 90 von 100 aus Silber, Kupfer oder Aluminium besteht.

5. Verbindungseinrichtung nach Anspruch 1,
wobei die Edelmetalloberflächen (160, 260, 400) der jeweiligen Kontaktbereiche (120, 220, 40, 42) eine Dicke zwischen 10nm und 150nm aufweist.

6. Verbindungseinrichtung nach Anspruch 1,
wobei das flexible Verbindungselement (4) einen bogenförmigen Verlauf (44) zwischen seinen beiden Kontaktbereichen (40, 42) aufweist.

7. Verfahren zur Herstellung einer Verbindungseinrichtung nach einem der Ansprüche 1 bis 6 **gekennzeichnet durch** die folgenden Schritte:
• Anordnung einer Paste mit Sintermetall (18, 28) auf den ersten (16) und zweiten (26), jeweils Edelmetalloberflächen (160, 260) aufweisenden, Kontaktbereichen der Kontaktflächen (120, 220);
• Anordnung des dritten Kontaktbereichs (40) des flexiblen Verbindungselements (4) auf dem Sintermetall (18) des ersten Kontaktbereichs (16) der ersten Kontaktfläche;
• Beaufschlagung der Kontakteinrichtung (4) auf den dritten Kontaktbereich (40) mit Druck und mit Temperatur;
• Anordnung des vierten Kontaktbereichs (42) des flexiblen Verbindungselements (4) auf dem Sintermetall (28) des zweiten Kontaktbereichs (26) der zweiten Kontaktfläche (120);
• Beaufschlagung der Kontakteinrichtung (4) auf den vierten Kontaktbereich (42) mit Druck und mit Temperatur.

8. Verfahren nach Anspruch 2,
wobei die Paste aus Sintermetall (18, 28) eine Mischung im Verhältnis zwischen 20:80 und 80:20 aus einem Lösungsmittel und Silberflocken mit einer maximalen Ausdehnung von 200µm ist.

9. Verfahren nach Anspruch 2,
wobei die Paste aus Sintermetall (18, 28) in einem Dispensverfahren auf den ersten (160) und zweiten (260) Edelmetalloberflächen angeordnet wird.

10. Verfahren nach Anspruch 2,
wobei die Druckbeaufschlagung mit einem Druck zwischen 5MPa und 80MPa erfolgt und die Temperaturbeaufschlagung mit einer Temperatur zwischen 100°C und 300°C erfolgt.
